# EUROPEAN PATENT APPLICATION

(11) **EP 4 345 900 A1**
(43) Date of publication of application: **03.04.2024**
(21) Application number: 23197455.1
(22) Date of filing: 14.09.2023
(51) Int. Cl.: H01L 27/02, H01L 21/308, H10B 12/00

(54) **METHOD OF FABRICATING SEMICONDUCTOR DEVICE**

(30) Priority: 30.09.2022 KR 20220125814
(71) Applicant: Samsung Electronics Co., Ltd., Suwon-si, Gyeonggi-do 16677 (KR)
(72) Inventor: KIM, Janghoon, 16677 Suwon-si (KR); YUN, Sangho, 16677 Suwon-si (KR); HWANG, Chan, 16677 Suwon-si (KR)
(74) Representative: Marks & Clerk LLP

(57) **Abstract**

A method of fabricating a semiconductor device, the method comprising: forming a mask layer on a substrate in which a cell region and a periphery region at least partially surrounding the cell region are defined; forming a first mask pattern comprising a plurality of cell lines extending on the mask layer in the cell region, the plurality of cell lines being separated from one another by a first interval and being parallel to each other, the first mask pattern further comprising a plurality of periphery lines extending on the mask layer in the periphery region, the plurality of periphery lines being separated from one another by a second interval that is less than the first interval, the plurality of periphery lines being parallel to each other; conformally forming, on the first mask pattern, a spacer layer of a thickness that is less than half of the first interval and greater than half of the second interval; etching the spacer layer to form a plurality of cell spacers on side walls of the plurality of cell lines, respectively, and to form a periphery mask covering all side walls and upper surfaces of the plurality of periphery lines; removing the plurality of cell lines to form, on the mask layer, a second mask pattern including the plurality of cell spacers and the periphery mask; etching the mask layer by using the second mask pattern as an etching mask, to form a plurality of cell patterns in the cell region and to form a single dam pattern in the periphery region; and removing the second mask pattern and the plurality of periphery lines to form, on the substrate, a third mask pattern having the plurality of cell patterns and the single dam pattern.

## Description

### TECHNICAL FIELD

The present disclosure relates to a semiconductor device, and more particularly, to a method of fabricating a semiconductor device.

### DISCUSSION OF THE RELATED ART

Recently, along with the rapid development of semiconductor process technology, the development of more highly integrated circuit elements has been accelerated, thereby resulting in a decrease in the total area of a unit cell. Therefore, an area which a capacitor may occupy in the unit cell has also decreased. For example, along with an increase in the degree of integration of circuit elements, such as dynamic random access memory (DRAM), an area of a unit cell has decreased, but a required capacitance has been maintained or increased. Accordingly, to form a fine photoresist pattern on a semiconductor substrate, extreme ultraviolet (EUV) light is used as a light source for an exposure apparatus.

### SUMMARY

A method of fabricating a semiconductor device includes forming a mask layer on a substrate in which a cell region and a periphery region at least partially surrounding the cell region are defined. The method includes forming a first mask pattern including a plurality of cell lines extends on the mask layer in the cell region. The cell lines are separated from one another by a first interval and are parallel to each other. The first mask pattern further includes a plurality of periphery lines extend on the mask layer in the periphery region and are separated from one another by a second interval that is less than the first interval. The periphery lines are parallel to each other. A spacer layer of a thickness that is less than half of the first interval and greater than half of the second interval is conformally formed on the first mask pattern. The spacer layer is etched to form a plurality of cell spacers on side walls of the plurality of cell lines, respectively, and to form a periphery mask covering all side walls and upper surfaces of the plurality of periphery lines. The plurality of cell lines are removed to form, on the mask layer, a second mask pattern having the plurality of cell spacers and the periphery mask. The mask layer is etched by using the second mask pattern as an etching mask, to form a plurality of cell patterns in the cell region and to form a single dam pattern in the periphery region. The second mask pattern and the plurality of periphery lines are removed to form, on the substrate, a third mask pattern including the plurality of cell patterns and the single dam pattern.

A method of fabricating a semiconductor device includes sequentially forming a lower mask layer and an upper mask layer on a substrate in which a cell region and a periphery region at least partially surrounding the cell region are defined. An extreme ultraviolet (EUV) photoresist pattern including a plurality of first line-and-space patterns is formed on the upper mask layer in the cell region, and a plurality of second line-and-space patterns is formed on the upper mask layer in the periphery region. The upper mask layer is etched by using the EUV photoresist pattern as an etching mask, to form a first mask pattern including a plurality of cell lines extending on the lower mask layer in the cell region that are separated from one another by a first interval and are parallel to each other, and to form a plurality of periphery lines extending on the lower mask layer in the periphery region and separated from one another by a second interval that is less than the first interval and are parallel to each other. A spacer layer of a thickness that is less than half of the first interval and greater than half of the second interval is conformally formed on the first mask pattern. The spacer layer is etched to form a plurality of cell spacers on side walls of the plurality of cell lines, respectively, and to form a periphery mask covering side walls and upper surfaces of the plurality of periphery lines. The plurality of cell lines are removed to form, on the lower mask layer, a second mask pattern having the plurality of cell spacers and the periphery mask. The lower mask layer is etched using the second mask pattern as an etching mask, to form a plurality of cell patterns in the cell region and to form a single dam pattern in the periphery region. The second mask pattern and the plurality of periphery lines are removed to form, on the substrate, a third mask pattern including the plurality of cell patterns and the single dam pattern.

A method of fabricating a semiconductor device includes forming a material layer on a substrate in which a cell region and a periphery region at least partially surrounding the cell region are defined. A mold layer including a support layer is formed on the material layer. A mask pattern is formed on the mold layer. The mold layer and the support layer are etched using the mask pattern as an etching mask, to form, in the cell region, a plurality of pattern holes exposing an upper surface of the material layer. A plurality of lower electrodes are formed by coating inner walls of the plurality of pattern holes with a conductive material. The forming of the mask pattern includes forming a mask layer on the mold layer. A first mask pattern including a plurality of cell lines extending on the mask layer in the cell region that are separated from one another by a first interval and are parallel to each other is formed. A plurality of periphery lines extending on the mask layer in the periphery region are separated from one another by a second interval that is less than the first interval and are parallel to each other. A spacer layer of a thickness that is less than half of the first interval and greater than half of the second interval is conformally formed on the first mask pattern. The spacer layer is etched to form a plurality of cell spacers on side walls of the plurality of cell lines, respectively, and to form a periphery mask covering side walls and upper surfaces of the plurality of periphery lines. The plurality of cell lines are removed to form, on the mask layer, a second mask pattern including the plurality of cell spacers and the periphery mask. The mask layer is etched using the second mask pattern as an etching mask, to form a plurality of cell patterns in the cell region and to form a single dam pattern in the periphery region. The second mask pattern and the plurality of periphery lines are removed.

At least some of the above and other features of the invention are set out in the claims.

### BRIEF DESCRIPTION OF THE DRAWINGS

Embodiments of the inventive concept will be more clearly understood from the following detailed description taken in conjunction with the accompanying drawings in which:
FIG. 1 is a plan view schematically illustrating a general mask;
FIG. 2 is a magnified cross-sectional view and plan view shown by magnifying a part AA of FIG. 1;
FIGS. 3 and 4 are structural diagrams schematically illustrating an extreme ultraviolet (EUV) exposure apparatus used in an embodiment of the present disclosure;
FIG. 5 is a flowchart illustrating a method of fabricating a semiconductor device, according to an embodiment of the present disclosure;
FIGS. 6A to 6K are cross-sectional views and plan views illustrating, in a process order, a method of fabricating a semiconductor device, according to an embodiment of the present disclosure;
FIG. 7 is a plan view illustrating a mask pattern used for a method of fabricating a semiconductor device, according to an embodiment of the present disclosure;
FIG. 8 is a magnified view of a part BB of FIG. 7 illustrating the honeycomb structure arrangement of a main pattern;
FIG. 9 is a flowchart illustrating a method of fabricating a semiconductor device, according to an embodiment of the present disclosure; and
FIGS. 10A to 10I are cross-sectional views illustrating, in a process order, a method of fabricating a semiconductor device, according to an embodiment of the present disclosure.

### DETAILED DESCRIPTION OF THE EMBODIMENTS

Hereinafter, embodiments are described in detail with reference to the accompanying drawings.

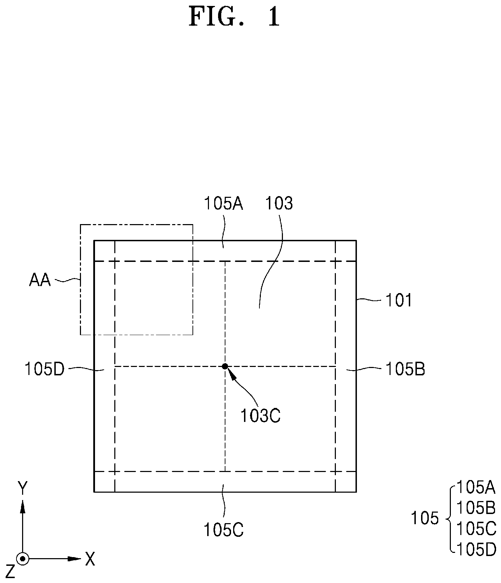

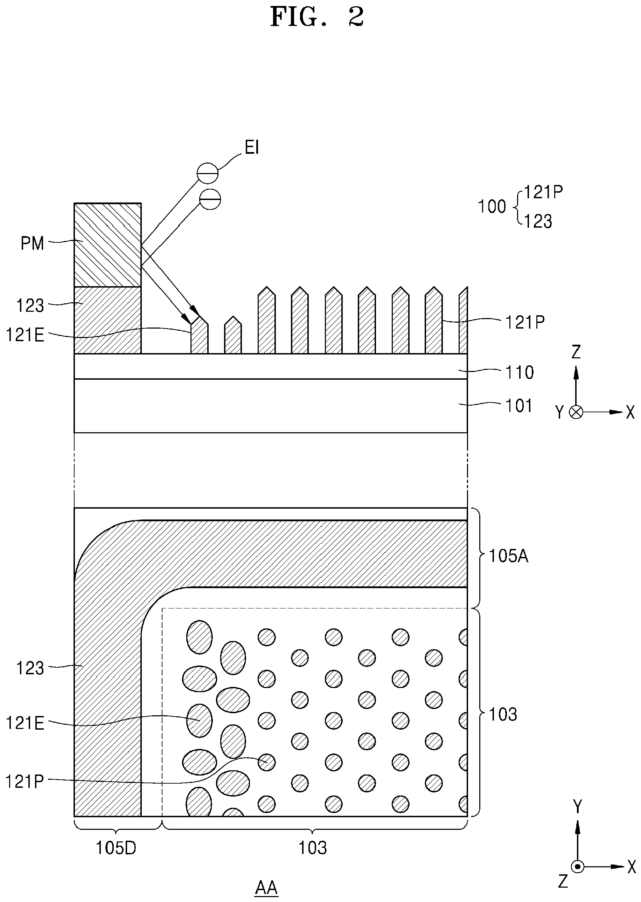

FIG. 1 is a plan view schematically illustrating a general mask, and FIG. 2 is a magnified cross-sectional view and plan view shown by magnifying a part AA of FIG. 1.

Referring to FIGS. 1 and 2, a mask pattern 100 may be disposed on a layer 110 to be etched, which is formed on a substrate 101.

The substrate 101 may include a semiconductor material, a group IV semiconductor, or a group III-V compound semiconductor. For example, the group IV semiconductor may include silicon (Si), germanium (Ge), or silicon germanium (SiGe).

The layer 110 to be etched may be disposed on the substrate 101. The layer 110 to be etched may include polysilicon but is not necessarily limited thereto.

The substrate 101 may include a cell region 103 and a periphery region 105 at least partially surrounding the cell region 103. The cell region 103 may include a central point 103C, and a main pattern 121P may be formed in the cell region 103. The periphery region 105 may include a first edge 105A and a third edge 105C extending in a first horizontal direction (e.g., X direction) at both sides of the cell region 103 and include a second edge 105B and a fourth edge 105D extending in a second horizontal direction (e.g., Y direction) that is perpendicular to the first horizontal direction (e.g., X direction) at the other two sides of the cell region 103.

The mask pattern 100 may be formed in different shapes in the cell region 103 and the periphery region 105. A plurality of main patterns 121P may be arranged in a honeycomb structure in the cell region 103. A detailed description of the honeycomb structure is provided below. A closed quadrilateral dam pattern, for example, a dam pattern 123, may be formed in the periphery region 105 along the first to fourth edges 105A, 105B 105C, and 105D.

In general, to form the plurality of main patterns 121P as a type of a plurality of circles in the cell region 103, a trim process may be performed by forming a photomask PM on the dam pattern 123. The trim process is a dry etching process, and if some etching ions EI are incident toward a side wall of the photomask PM, edge patterns 121E formed near the periphery region 105, among the plurality of main patterns 121P in the cell region 103, may be damaged. These damaged edge patterns 121E may cause a defect of a semiconductor device in a subsequent process.

To efficiently remove this defect, the development of a technique capable of performing a trim process even without using the photomask PM may be performed. Hereinafter, to this end, a method of fabricating a semiconductor device, according to an embodiment of the present disclosure, is particularly described.

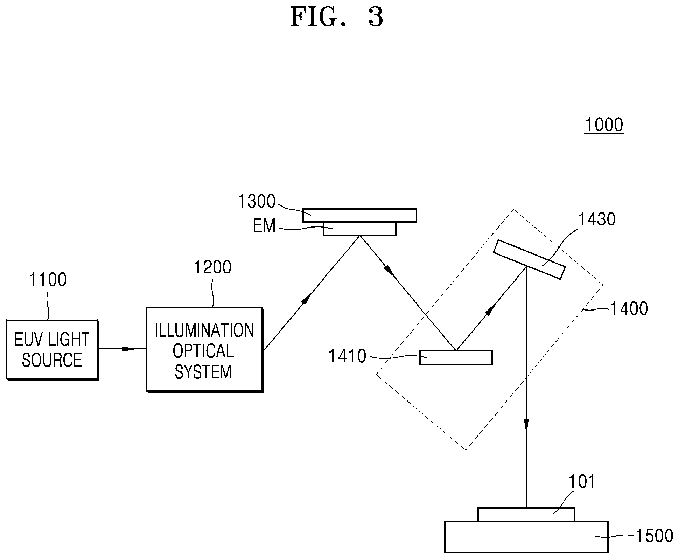

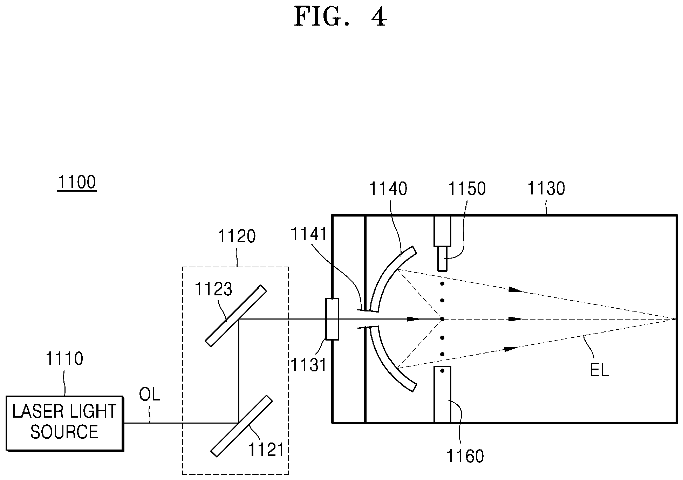

FIGS. 3 and 4 are structural diagrams schematically illustrating an extreme ultraviolet (EUV) exposure apparatus 1000 used in an embodiment of the present disclosure.

Referring to FIGS. 3 and 4, the EUV exposure apparatus 1000 may include an EUV light source 1100, an illumination optical system 1200, a reticle support 1300, a projection optical system 1400, and a substrate stage 1500.

The EUV light source 1100 may generate and output EUV light EL having a high energy density. For example, the EUV light EL radiated from the EUV light source 1100 may have a wavelength of about 4 nm to about 124 nm. In some embodiments, the EUV light EL may have a wavelength of about 4 nm to about 20 nm, e.g., about 13.5 nm.

The EUV light source 1100 may be a plasma-based light source or a synchrotron radiation light source. Herein, the plasma-based light source indicates a light source in a scheme of generating plasma and using light emitted by the plasma and may include a laser-produced plasma light source, a discharge-produced plasma light source, or the like.

The EUV light source 1100 may include a laser light source 1110, a transmission optical system 1120, a vacuum chamber 1130, a collector mirror 1140, a droplet generator 1150, and a droplet catcher 1160.

The laser light source 1110 may be configured to output laser light OL. For example, the laser light source 1110 may output carbon dioxide laser light. The laser light OL output from the laser light source 1110 may be incident to a window 1131 of the vacuum chamber 1130 through a plurality of reflective mirrors 1121 and 1123 included in the transmission optical system 1120 and introduced to the inside of the vacuum chamber 1130.

An aperture 1141 through which the laser light OL passes may be formed at a central part of the collector mirror 1140, and the laser light OL may be introduced to the inside of the vacuum chamber 1130 through the aperture 1141 of the collector mirror 1140.

The droplet generator 1150 generate a droplet, which interacts with the laser light OL to generate the EUV light EL, and to provide the droplet to the inside of the vacuum chamber 1130. The droplet may include tin (Sn), lithium (Li), and/or xenon (Xe). For example, the droplet may include Sn, tin compounds (e.g., tin(IV) bromide (SnBr₄), tin(II) bromide (SnBr₂), and/or tin hydrogen (SnH)), tin alloys (e.g., tin gallium (Sn-Ga), tin indium (Sn-In), and/or tin indium gallium (Sn-In-Ga)).

The droplet catcher 1160 may be disposed under the droplet generator 1150 and may be configured to catch a droplet which has not reacted with the laser light OL. The droplet provided from the droplet generator 1150 may generate the EUV light EL by reacting with the laser light OL introduced to the inside of the vacuum chamber 1130. The collector mirror 1140 may collect and reflect the EUV light EL and emit the EUV light EL to the illumination optical system 1200 that is disposed outside of the vacuum chamber 1130.

The illumination optical system 1200 may include a plurality of reflective mirrors and may transmit the EUV light EL emitted from the EUV light source 1100 to an EUV mask EM. For example, the EUV light EL emitted from the EUV light source 1100 may be reflected from the plurality of reflective mirrors in the illumination optical system 1200 and be incident to the EUV mask EM on the reticle support 1300.

The EUV mask EM may be a reflective mask having a reflective region and a non-reflective (or intermediate reflective) region. The EUV mask EM may include a reflective multi-layer formed on a mask substrate and of a material, such as Si, having a low thermal expansion rate and an absorptive pattern formed on the reflective multi-layer. Herein, the reflective multi-layer may correspond to the reflective region, and the absorptive pattern may correspond to the non-reflective (or intermediate reflective) region.

The EUV mask EM may reflect the EUV light EL incident through the illumination optical system 1200 so that the EUV light EL is incident to the projection optical system 1400. For example, the EUV mask EM may structurize light incident from the illumination optical system 1200 to projection light based on a mask pattern formed with the reflective multi-layer and the absorptive pattern of the mask substrate, so that the projection light is incident to the projection optical system 1400. The projection light may be structurized through at least second order of diffraction due to the EUV mask EM. This projection light may be incident to the projection optical system 1400 while containing information about the mask pattern of the EUV mask EM and may form, on the substrate 101, an image corresponding to the mask pattern of the EUV mask EM by passing through the projection optical system 1400.

The projection optical system 1400 may include a plurality of reflective mirrors 1410 and 1430. Although FIG. 3 shows two reflective mirrors 1410 and 1430 in the projection optical system 1400, the projection optical system 1400 may include three or more reflective mirrors. For example, the projection optical system 1400 may generally include four to eight reflective mirrors. However, the number of reflective mirrors included in the projection optical system 1400 is not necessarily limited thereto.

The substrate 101 may be disposed on the substrate stage 1500. The substrate stage 1500 may be configured to move in three dimensions. The movement of the substrate stage 1500 may cause the substrate 101 to also move in the same direction as the moving direction of the substrate stage 1500.

The EUV exposure apparatus 1000 may be used to form, on the substrate 101, an EUV photoresist pattern having a resolution of the EUV light EL, and a semiconductor device, according to the technical idea of the inventive concept, may be fabricated using the EUV photoresist pattern as an etching mask.

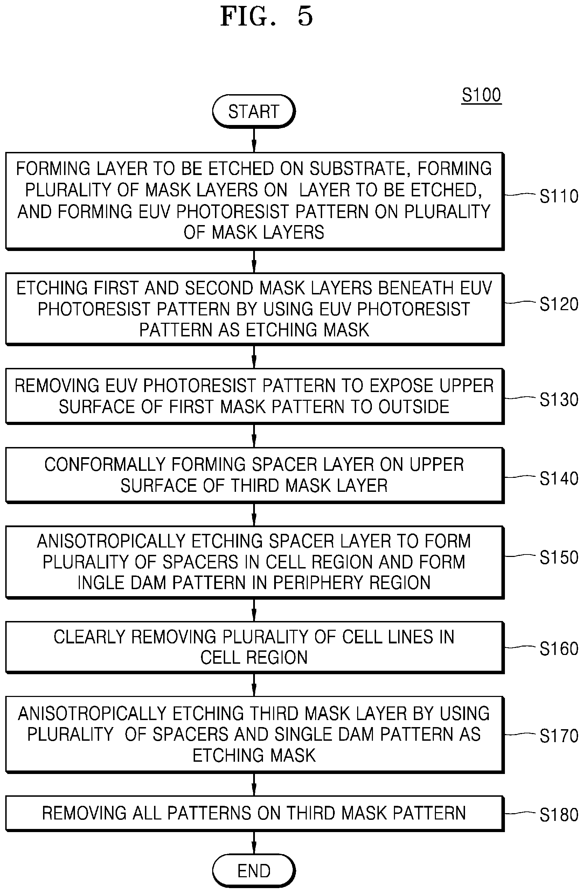

FIG. 5 is a flowchart illustrating a method S100 of fabricating a semiconductor device, according to an embodiment of the present disclosure.

Referring to FIG. 5, the method S100 of fabricating a semiconductor device may include first to eighth operations S110 to S180 in a process order.

If a certain embodiment is implemented differently, a particular process order that is different from the process order to be described below may be performed. For example, two operations consecutively described may be performed substantially at the same time or in a reverse order.

The method S100 of fabricating a semiconductor device, according the technical idea of the inventive concept, may include the first operation S110 of forming a layer to be etched on a substrate, forming a plurality of mask layers on the layer to be etched, and forming an EUV photoresist pattern on the plurality of mask layers. In the second operation S120, first and second mask layers may be etched beneath the EUV photoresist pattern by using the EUV photoresist pattern as an etching mask. In the third operation S130, the EUV photoresist pattern may be removed to expose an upper surface of a first mask pattern. In the fourth operation S140, a spacer layer is conformally formed on an upper surface of a third mask layer. In the fifth operation S150, the spacer layer is anisotropically etched to form a plurality of spacers in a cell region and to form a single dam pattern in a periphery region. In the sixth operation S160, a plurality of cell lines in the cell region are removed. In the seventh operation S170, the third mask layer is anisotropically etched by using the plurality of spacers and the single dam pattern as an etching mask. In the eighth operation S180, the patterns on a third mask pattern are removed.

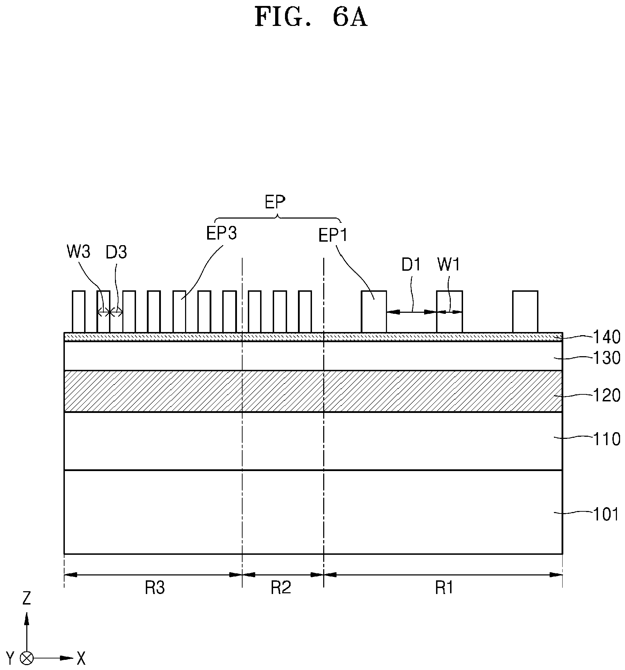

The respective technical features of the first to eighth operations S110 to S180 are described in detail with reference to FIGS. 6A to 6K below.

FIGS. 6A to 6K are cross-sectional views and plan views illustrating, in a process order, a method of fabricating a semiconductor device, according to an embodiment of the present disclosure.

Referring to FIG. 6A, the layer 110 to be etched may be formed on the substrate 101. A plurality of mask layers 120, 130, and 140 may be formed on the layer 110 to be etched. An EUV photoresist pattern EP may be formed on the plurality of mask layers 120, 130, and 140.

The substrate 101 may include a semiconductor material, a group IV semiconductor, or a group III-V compound semiconductor. For example, the group IV semiconductor may include Si, Ge, or SiGe. The substrate 101 may be provided as a bulk wafer or a wafer including an epitaxial layer. Unit devices, such as various types of active devices or passive devices, required to form a semiconductor device may be formed on the substrate 101.

The substrate 101 may be partitioned into a cell region R1 and an edge region R3 at least partially surrounding the cell region R1, and an interface region R2 may be included between the cell region R1 and the edge region R3. For convenience of description, the interface region R2 and the edge region R3 are referred to as a periphery region R2 and R3.

The layer 110 to be etched may be disposed on the substrate 101. The layer 110 to be etched may be a single layer or a multi-layer stacked with a plurality of material layers. The layer 110 to be etched may be a material layer having an etch selectivity to the plurality of mask layers 120, 130, and 140. For example, the layer 110 to be etched may include polysilicon but is not necessarily limited thereto.

The plurality of mask layers 120, 130, and 140 may include various material layers to form a target pattern on the layer 110 to be etched. The plurality of mask layers 120, 130, and 140 may include a third mask layer 120, a second mask layer 130, and a first mask layer 140. The third mask layer 120 may be formed on the substrate 101, the second mask layer 130 may be formed on the third mask layer 120, and the first mask layer 140 may be formed on the second mask layer 130.

In addition, the plurality of mask layers 120, 130, and 140 may be formed with various thicknesses to form the target pattern on the layer 110 to be etched. For example, a thickness of the second mask layer 130 may be greater than a thickness of the first mask layer 140.

The EUV photoresist pattern EP may be formed on the first mask layer 140. The EUV photoresist pattern EP may be formed using the EUV exposure apparatus 1000 (see FIG. 3) described above by exposure and development after forming a photoresist layer reacting with EUV light.

The EUV photoresist pattern EP may include a plurality of line patterns EP1 and EP3 depending on forming positions thereof. For convenience of description, line patterns formed in the cell region R1, among the plurality of line patterns EP1 and EP3, are referred to as a plurality of cell line patterns EP1, and line patterns formed in the periphery region R2 and R3, among the plurality of line patterns EP1 and EP3, are referred to as a plurality of periphery line patterns EP3.

The plurality of cell line patterns EP1 may be a plurality of first line-and-space patterns separated by the same first interval D1 from each other in the first horizontal direction (e.g., X direction) and extending in parallel to each other in the second horizontal direction (e.g., Y direction) with the same first width W1 of a mask line.

The plurality of periphery line patterns EP3 may be a plurality of second line-and-space patterns separated by the same second interval D3 from each other in the first horizontal direction (e.g., X direction) and extending in parallel to each other in the second horizontal direction (e.g., Y direction) with the same second width W3 of a mask line but are not necessarily limited thereto.

Herein, the first interval D1 of the plurality of cell line patterns EP1 may be greater than the second interval D3 of the plurality of periphery line patterns EP3. In addition, the first width W1 of the plurality of cell line patterns EP1 may be greater than the second width W3 of the plurality of periphery line patterns EP3.

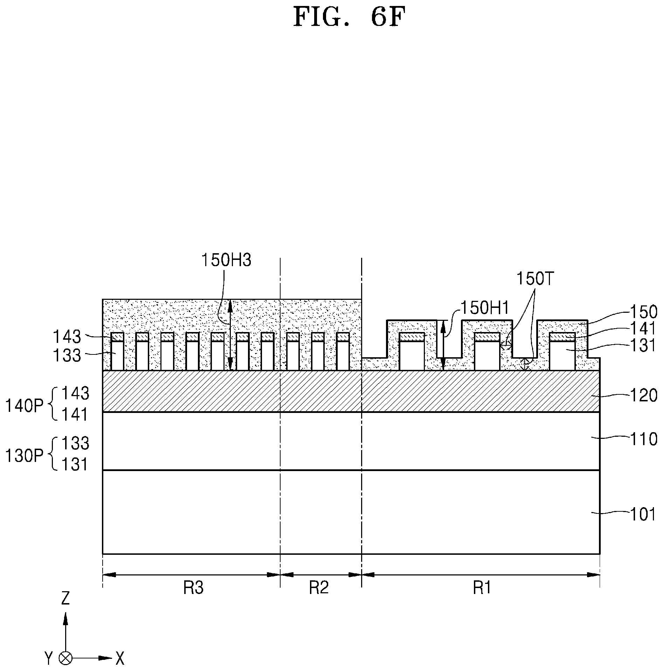

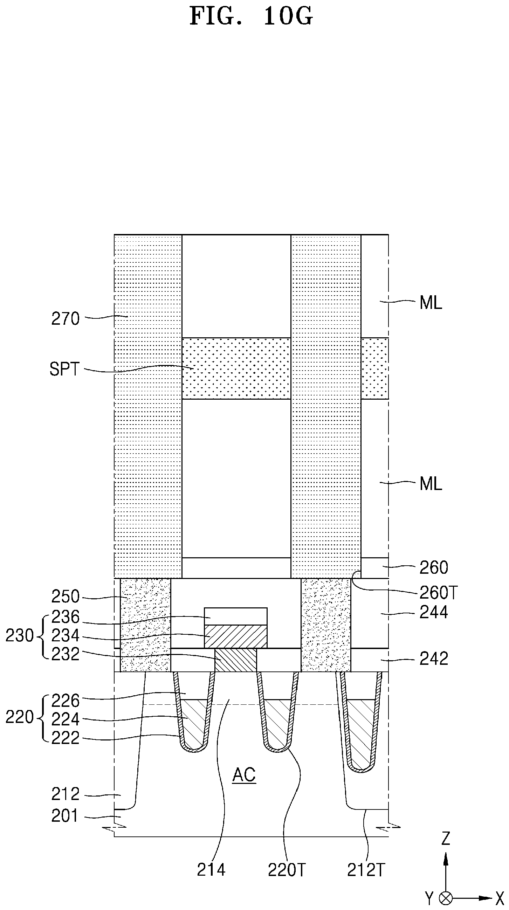

The first interval D1 and the first width W1 of the plurality of cell line patterns EP1 may be determined depending on the size and arrangement of a lower electrode 270 (see FIG. 10G) to be finally formed. Unlike the plurality of cell line patterns EP1, the second interval D3 and the second width W3 of the plurality of periphery line patterns EP3 may be determined depending on the thickness of a spacer layer 150 (see FIG. 6F) to be formed in a subsequent process.

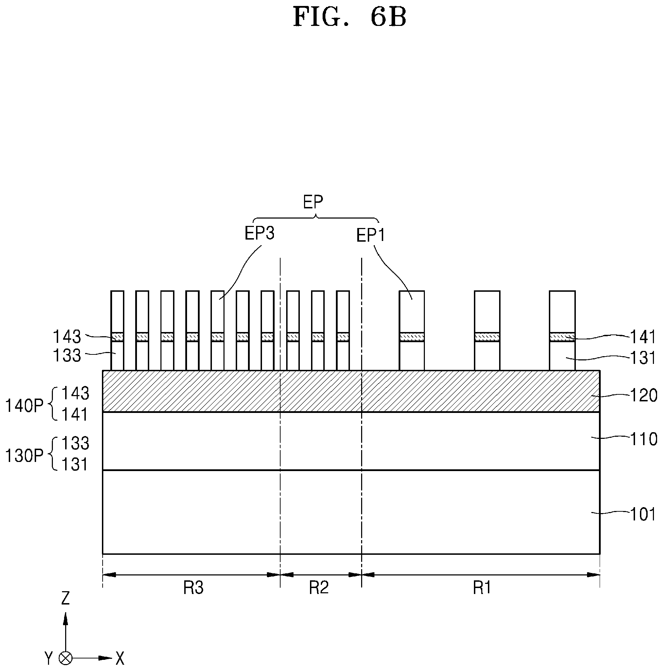

Referring to FIG. 6B, the first and second mask layers 140 and 130 beneath the EUV photoresist pattern EP may be sequentially etched by using the EUV photoresist pattern EP as an etching mask.

A first mask pattern 130P and 140P may be formed by using the EUV photoresist pattern EP as an etching mask to anisotropically etch the first and second mask layers 140 and 130. For convenience of description, lines of the first mask pattern 130P and 140P formed in the cell region R1 are referred to as a plurality of cell lines 131 and 141, and lines of the first mask pattern 130P and 140P formed in the periphery region R2 and R3 are referred to as a plurality of periphery lines 133 and 143.

For example, a reactive ion etching (RIE) method or an inductive coupled plasma (ICP) etching method may be used as an anisotropic etching method of forming the first mask pattern 130P and 140P but is not necessarily limited thereto.

Accordingly, the plurality of cell lines 131 and 141 may have a line shape corresponding to the plurality of cell line patterns EP1, and the plurality of periphery lines 133 and 143 may have a line shape corresponding to the plurality of periphery line patterns EP3.

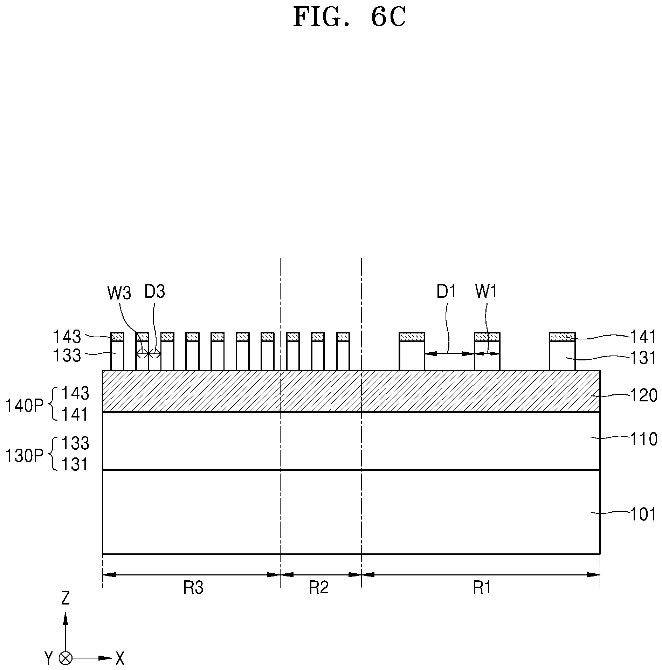

Referring to FIG. 6C, the EUV photoresist pattern EP (see FIG. 6B) may be removed to expose an upper surface of an upper pattern 140P of the first mask pattern 130P and 140P to the outside.

The EUV photoresist pattern EP (see FIG. 6B) may be removed using an ashing and strip process. A process of removing the EUV photoresist pattern EP (see FIG. 6B) may be performed under a condition that etching of the first mask pattern 130P and 140P is suppressed.

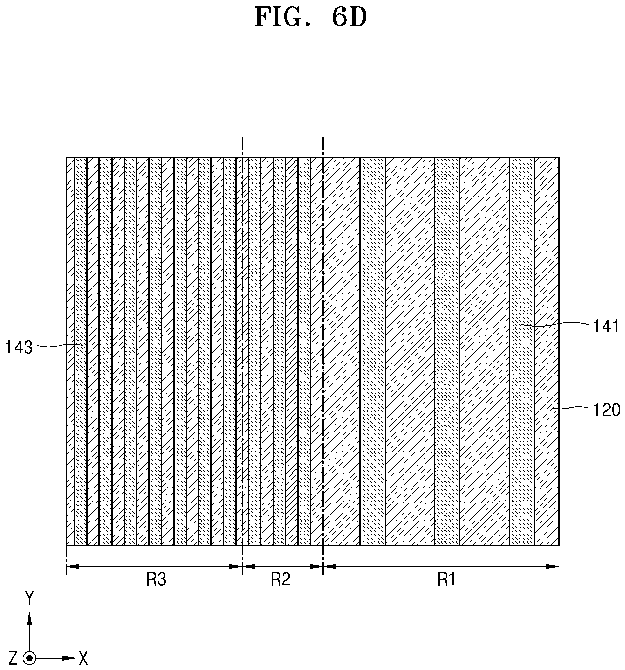

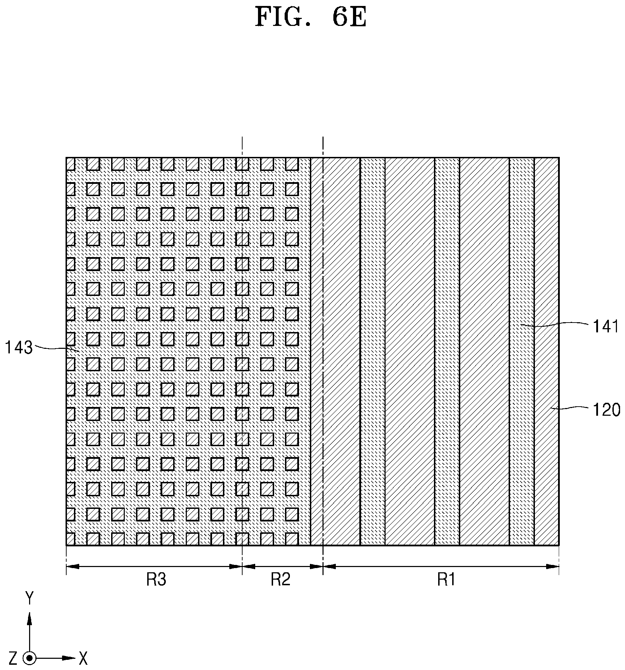

Referring to FIGS. 6D and 6E, the first mask pattern 130P and 140P may be formed to have various shapes.

For example, the first mask pattern 130P and 140P may have a shape in which the plurality of cell lines 131 and 141 are at least partially surrounded by the plurality of periphery lines 133 and 143 on the third mask layer 120.

In some embodiments, as shown in FIG. 6D, when viewing the substrate 101 from the top in a vertical direction (e.g., Z direction), the plurality of periphery lines 133 and 143 may be formed in a shape of a plurality of lines and spaces.

In some embodiments, as shown in FIG. 6E, when viewing the substrate 101 from the top in the vertical direction (e.g., Z direction), the plurality of periphery lines 133 and 143 may be formed in a connected mesh shape.

As described above, the plurality of periphery lines 133 and 143 may be formed in various shapes, which may exhibit an overlapping effect due to a loading effect of the spacer layer 150 (see FIG. 6F) to be formed in a subsequent process.

Referring to FIG. 6F, the spacer layer 150 may be conformally formed on the exposed surface of the first mask pattern 130P and 140P and an upper surface of the third mask layer 120.

The spacer layer 150 may be formed by, for example, a chemical vapor deposition (CVD) process or an atomic layer deposition (ALD) process. The forming the spacer layer 150 is not necessarily limited thereto.

The spacer layer 150 may include a material having an etch selectivity to the third mask layer 120 and the first mask pattern 130P and 140P but is not necessarily particularly limited thereto. For example, the spacer layer 150 may include silicon oxide.

The spacer layer 150 may be conformally formed with a thickness 150T, which is less than half of the first interval D1 and greater than half of the second interval D3, along a side wall and an upper surface of the first mask pattern 130P and 140P.

As described above, according to the thickness 150T of the spacer layer 150 and different region-based intervals of the first mask pattern 130P and 140P, the following phenomenon may occur. For example, a first height 150H1 of the spacer layer 150 from the upper surface of the third mask layer 120 in the cell region R1 may differ from a second height 150H3 of the spacer layer 150 from the upper surface of the third mask layer 120 in the periphery region R2 and R3.

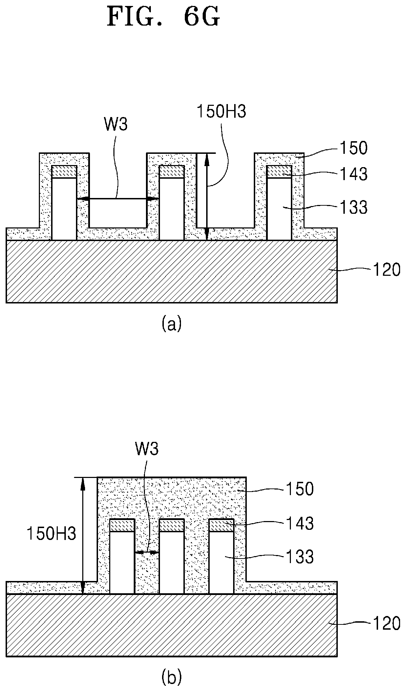

Referring to FIGS. 6F and 6G, a loading effect according to a difference between the intervals of the first mask pattern 130P and 140P is described.

Herein, the loading effect indicates a phenomenon that a formed thickness of a material layer (herein, the spacer layer 150) formed on a pattern varies according to a pattern density difference and/or a pattern size difference.

As shown in FIG. 6G, structure (a), when the plurality of periphery lines 133 and 143 are formed with a relatively large interval in the periphery region R2 and R3, for example, when the spacer layer 150 is formed with the thickness 150T that is less than half of the second interval D3, the spacer layer 150 may be conformally formed with the same thickness 150T on side walls and upper surfaces of the plurality of periphery lines 133 and 143.

Unlike FIG. 6G, structure (a), as shown in FIG. 6G, structure (b), when the plurality of periphery lines 133 and 143 are formed with a relatively small interval in the periphery region R2 and R3, for example, when the spacer layer 150 is formed with the thickness 150T that is greater than half of the second interval D3, the thickness 150T of the spacer layer 150 on the upper surfaces of the plurality of periphery lines 133 and 143 may be greater than the thickness 150T of the spacer layer 150 on the side walls of the plurality of periphery lines 133 and 143.

Therefore, the second height 150H3 from the upper surface of the third mask layer 120 to the highest upper surface of the spacer layer 150 may differ in FIG. 6G, structure (a) and FIG. 6G, structure (b).

In the method of fabricating a semiconductor device, according to the technical idea of the inventive concept, this effect may be used to use the spacer layer 150 as a mask in the periphery region R2 and R3. In this case, by substituting the spacer layer 150 for the photomask PM (see FIG. 2) additionally formed for a trim process, defects due to the photomask PM (see FIG. 2) described above may be dramatically reduced.

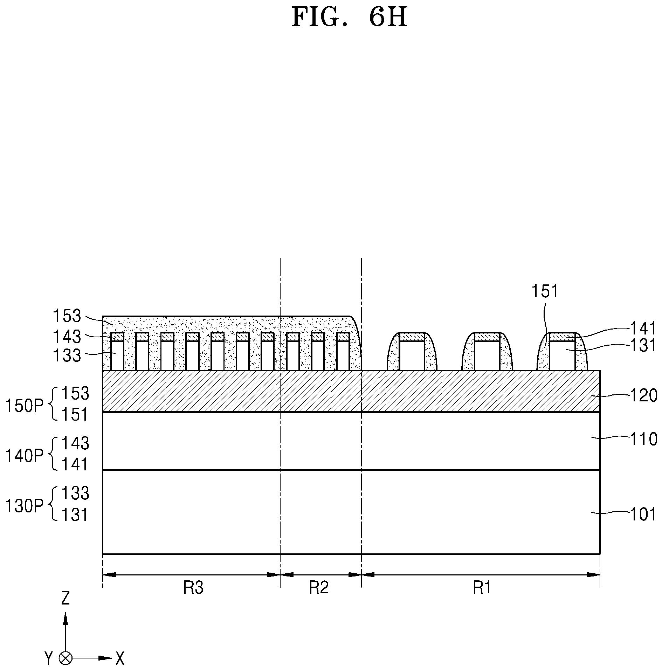

Referring to FIG. 6H, the spacer layer 150 (see FIG. 6F) may be anisotropically etched to form a plurality of spacers 151 in the cell region R1 and form a single periphery mask 153 in the periphery region R2 and R3.

To form the plurality of spacers 151 and the single periphery mask 153, an anisotropic dry etching process using etching gas in an etching chamber may be performed.

The spacer layer 150 (see FIG. 6F) may be etched to expose, to the outside, upper surfaces of upper lines 141 of the plurality of cell lines 131 and 141 in the cell region R1. Accordingly, due to different region-based heights of the spacer layer 150 (see FIG. 6F), upper surfaces of upper lines 143 of the plurality of periphery lines 133 and 143 might not be exposed to the outside in the periphery region R2 and R3.

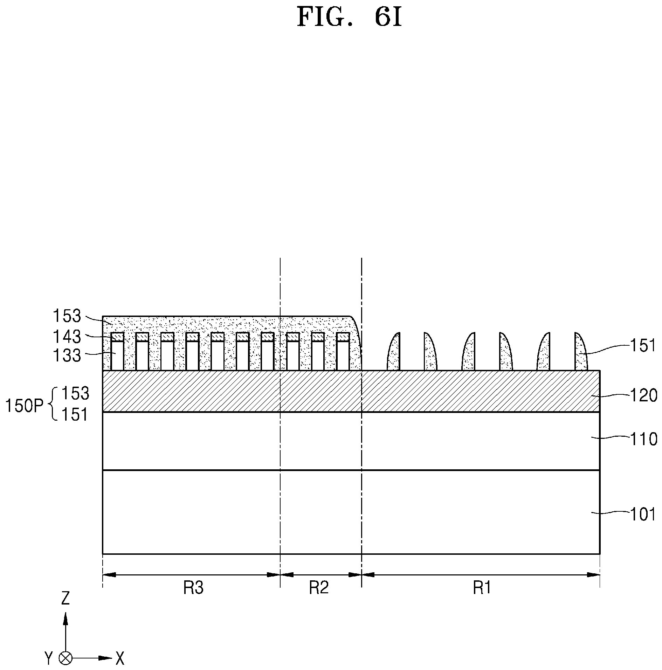

Referring to FIG. 6I, after forming the plurality of spacers 151, the plurality of cell lines 131 and 141 (see FIG. 6H) in the cell region R1 may be removed.

According to a structural material of the plurality of cell lines 131 and 141 (see FIG. 6H), the plurality of cell lines 131 and 141 (see FIG. 6H) may be removed using a wet or dry etching process. The removal of the plurality of cell lines 131 and 141 (see FIG. 6H) may be performed under a condition that etching of the plurality of spacers 151 and the single periphery mask 153 is suppressed.

In the wet or dry etching process, because the plurality of periphery lines 133 and 143 are still protected by the single periphery mask 153, in a process of removing the plurality of cell lines 131 and 141 (see FIG. 6H), the plurality of periphery lines 133 and 143 may still remain without being removed.

Accordingly, a second mask pattern 150P including the plurality of spacers 151 and the single periphery mask 153 may be formed.

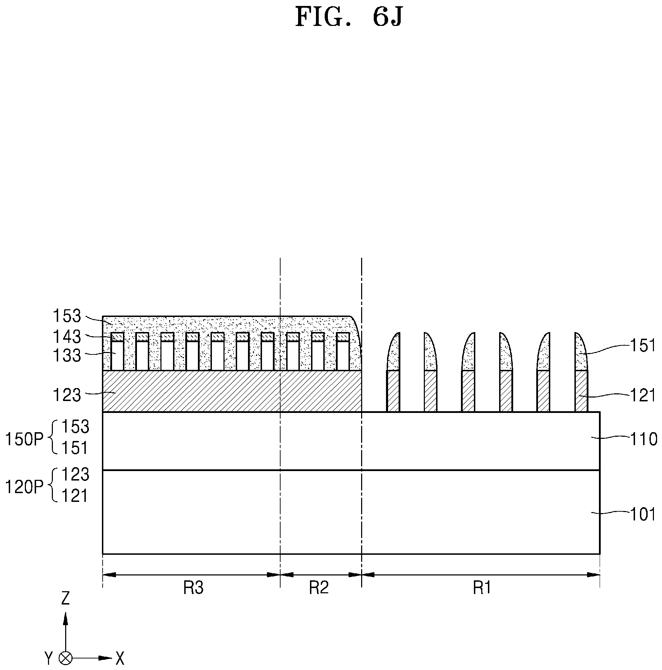

Referring to FIG. 6J, a third mask pattern 120P may be formed by using the plurality of spacers 151 and the single periphery mask 153 as an etching mask to anisotropically etch the third mask layer 120.

For example, the third mask pattern 120P may be formed by using the second mask pattern 150P as an etching mask to anisotropically etch the third mask layer 120. This scheme is referred to as a double patterning process.

In the double patterning process of forming the third mask pattern 120P, for example, an RIE method or an ICP etching method may be used. For convenience of description, a pattern of the third mask pattern 120P formed in the cell region R1 is referred to as a cell pattern 121, and a pattern of the third mask pattern 120P formed in the periphery region R2 and R3 is referred to as the dam pattern 123.

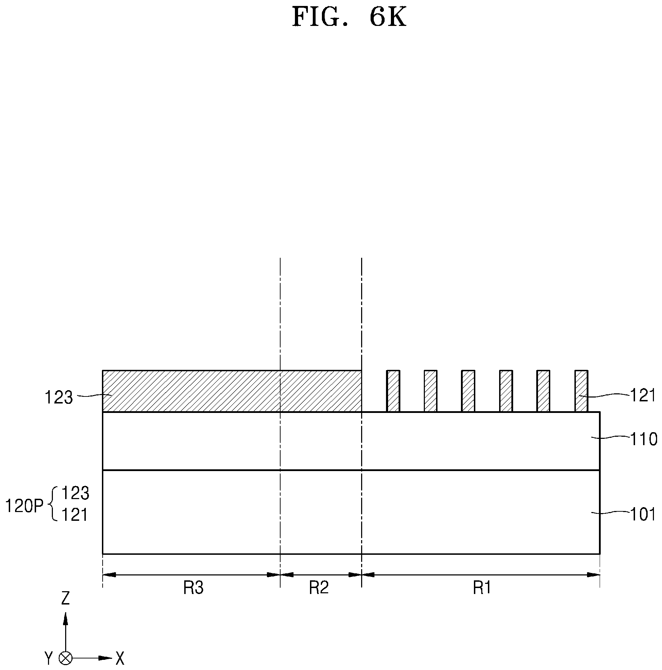

Referring to FIG. 6K, all patterns on the third mask pattern 120P may be removed.

For example, the plurality of spacers 151 may be removed in the cell region R1, and all of the single periphery mask 153 and the plurality of periphery lines 133 and 143 protected by the single periphery mask 153 may be removed in the periphery region R2 and R3.

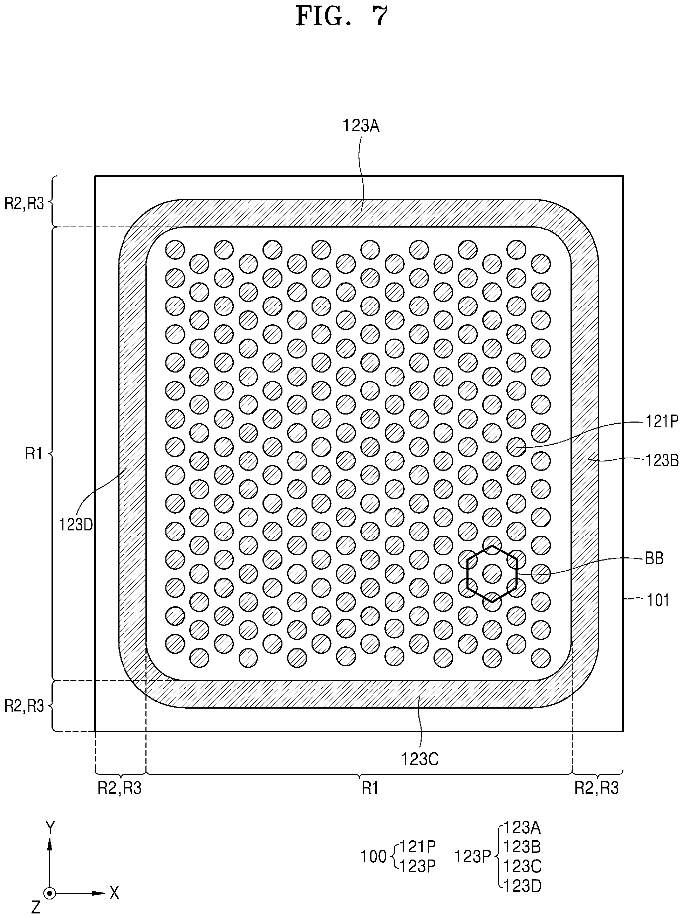

The cell pattern 121 in the cell region R1 may function as a main pattern 121P (see FIG. 7) for forming a lower electrode 270 (see FIG. 10G) of a semiconductor device.

The dam pattern 123 in the periphery region R2 and R3 may function as a periphery pattern 123P (see FIG. 7) for protecting dummy patterns of a semiconductor device in a trim process on the layer 110 to be etched beneath the third mask pattern 120P.

The removal process may be performed under a condition that etching of the third mask pattern 120P and the layer 110 to be etched is suppressed. By doing this, an etching mask including the cell pattern 121 and the dam pattern 123 having different shapes may be formed using an EUV photolithography process only once.

The method of fabricating a semiconductor device, according to the technical idea of the inventive concept, may implement a desired mask pattern even without additionally performing an exposure process on any one of different regions of the substrate 101 by forming a plurality of line patterns disposed at different intervals on the different regions, respectively, and applying a double patterning process to the plurality of line patterns.

FIG. 7 is a plan view illustrating the mask pattern 100 used for a method of fabricating a semiconductor device, according to an embodiment of the present disclosure.

Referring to FIG. 7, the mask pattern 100 including the plurality of main patterns 121P disposed on the substrate 101 in the first horizontal direction (e.g., X direction) and the second horizontal direction (e.g., Y direction), and a closed quadrilateral periphery pattern, for example, a periphery pattern 123P, having four edges 123A, 123B, 123C, and 123D is shown. For convenience of description, the mask pattern 100 is shown.

On the substrate 101, the cell region R1 and the periphery region R2 and R3 at least partially surrounding the cell region R1 may be defined. In the cell region R1, a plurality of transistors, a plurality of capacitors, and the like may be formed.

In the cell region R1, the plurality of main patterns 121P may be arranged in a honeycomb structure. In the periphery region R2 and R3, the closed quadrilateral periphery pattern, for example, the periphery pattern 123P, may at least partially surround the plurality of main patterns 121P.

To form the plurality of main patterns 121P and the periphery pattern 123P, a photography process using the EUV mask EM (see FIG. 3), according to an embodiment of the present disclosure, may be performed as described above.

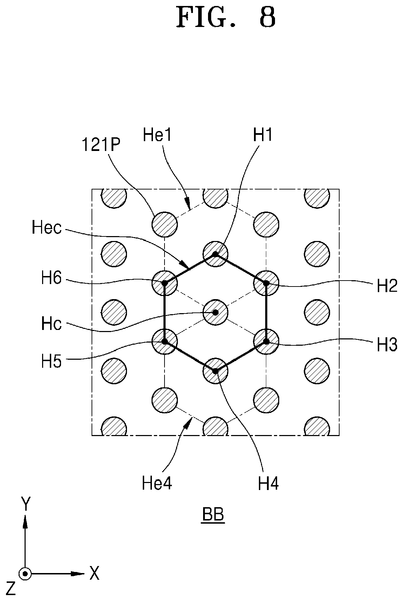

FIG. 8 is a magnified view of a part BB of FIG. 7 to describe the honeycomb structure arrangement of a main pattern.

Referring to FIG. 8, the plurality of main patterns 121P on the substrate 101, according to the technical idea of the inventive concept, may be arranged in a honeycomb structure.

The honeycomb structure may have a structure in which the plurality of main patterns 121P are arranged with first to sixth vertices H1, H2, H3, H4, H5, and H6 and a central point Hc of a hexagon. As shown in FIG. 8, the plurality of main patterns 121P may be arranged in a structure in which the honeycomb structure continues in the first horizontal direction (e.g., X direction) and the second horizontal direction (e.g., Y direction) in an overlapping manner.

For example, the plurality of main patterns 121P may be arranged in a structure in which each of the six vertices H1, H2, H3, H4, H5, and H6 of a central hexagon Hec (shown as a solid line) becomes a central point of each of six hexagons adjacent to the central hexagon Hec, and the central point Hc of the central hexagon Hec is shared by the six hexagons.

For example, the first vertex H1 may be a central point of a first hexagon He1 (shown as a dashed line), the fourth vertex H4 may be a central point of a fourth hexagon He4 (shown as an alternated long and short dash line), and the central point Hc of the central hexagon Hec may be shared as one of the six vertices of the first hexagon He1 and one of the six vertices of the fourth hexagon He4.

In the honeycomb structure of the plurality of main patterns 121P, a hexagon may be a regular hexagon. In addition, all of six triangles sharing the central point Hc may be regular triangles. Accordingly, in a single hexagon, distances between neighboring vertices or distances between the vertices and a central point may be the same as each other.

As described above, by arranging the plurality of main patterns 121P in the honeycomb structure, the plurality of main patterns 121P may maintain a certain distance therebetween with substantially the same circle type.

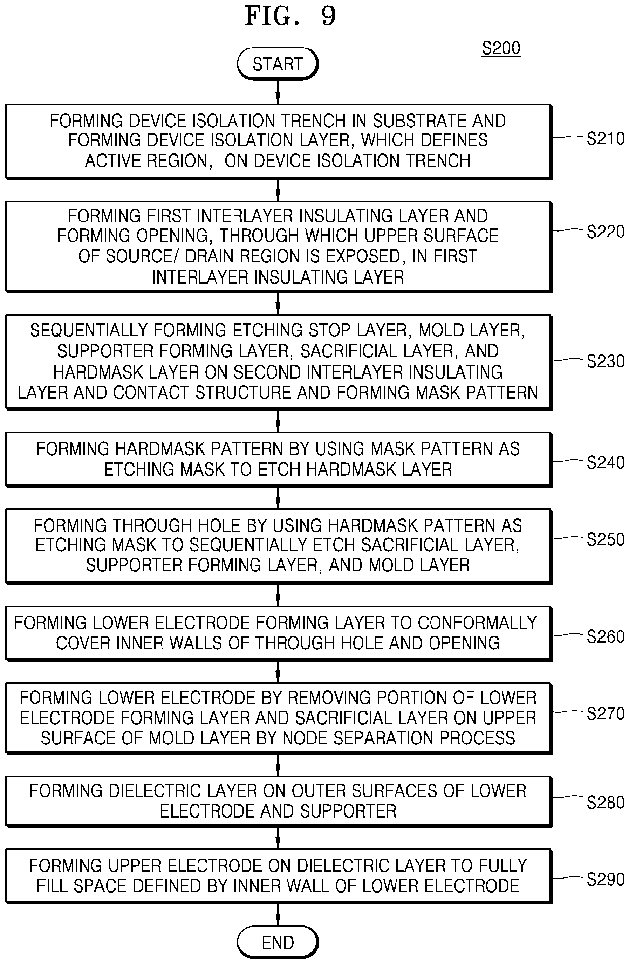

FIG. 9 is a flowchart illustrating a method S200 of fabricating a semiconductor device, according to an embodiment of the present disclosure.

Referring to FIG. 9, the method S200 of fabricating a semiconductor device may include first to ninth operations S210 to S290 in a process order.

If a certain embodiment is implemented differently, a particular process order that is different from the process order to be described below may be performed. For example, two operations consecutively described may be performed substantially at the same time or in a reverse order.

The method S200 of fabricating a semiconductor device, according to the technical idea of the inventive concept, may include the first operation S210 of forming a device isolation trench in a substrate and forming a device isolation layer, which defines an active region, on the device isolation trench. In the second operation S220, a first interlayer insulating layer is formed and an opening, through which an upper surface of a source/drain region is exposed, is formed in the first interlayer insulating layer. In the third operation S230, an etching stop layer, a mold layer, a supporter forming layer, a sacrificial layer, and a hardmask layer are sequentially formed on a second interlayer insulating layer and a contact structure and a mask pattern is formed. In the fourth operation S240, a hardmask pattern is formed by using the mask pattern as an etching mask to etch the hardmask layer. In the fifth operation S250, a through hole is formed by using the hardmask pattern as an etching mask to sequentially etch the sacrificial layer, the supporter forming layer, and the mold layer. In the sixth operation S260, a lower electrode forming layer is formed to conformally cover inner walls of the through hole and the opening. In the seventh operation S270, a lower electrode is formed by removing a portion of the lower electrode forming layer and the sacrificial layer on an upper surface of the mold layer by a node separation process. In the eighth operation S280, a dielectric layer is formed on the outer surfaces of the lower electrode and a supporter. In the ninth operation S290, an upper electrode is formed on the dielectric layer to fill a space defined by an inner wall of the lower electrode.

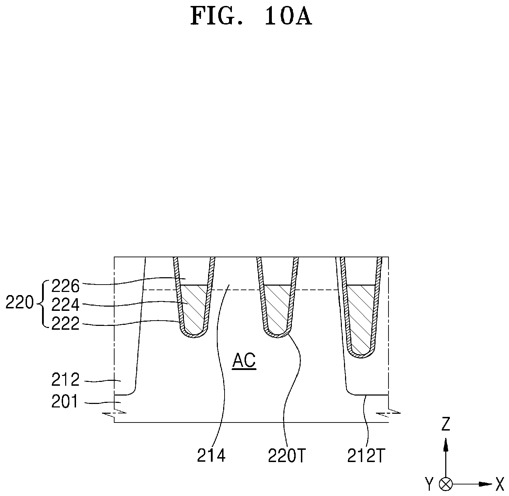

The respective technical features of the first to ninth operations S210 to S290 are described in detail with reference to FIGS. 10A to 10I below.

FIGS. 10A to 10I are cross-sectional views illustrating, in a process order, a method of fabricating a semiconductor device, according to an embodiment of the present disclosure.

Referring to FIG. 10A, a device isolation trench 212T may be formed in a substrate 201, and a device isolation layer 212 defining an active region AC may be formed on the device isolation trench 212T.

Next, gate line trenches 220T may be formed in the substrate 201. The gate line trenches 220T may extend in parallel to each other and have a line shape crossing the active region AC.

Next, a gate insulating layer 222 may be formed on an inner wall of the gate line trench 220T. A gate electrode layer 224 may be formed by forming, on the gate insulating layer 222, a gate conductive layer filling the inside of the gate line trench 220T and then removing an upper part of the gate conductive layer to a certain height by an etch-back process.

Next, a gate capping layer 226 may be formed on the inner wall of the gate line trench 220T by forming an insulating material to fill a remaining part of the gate line trench 220T and planarizing the insulating material so that an upper surface of the substrate 201 is exposed.

Next, a source/drain region 214 may be formed at both sides of a gate structure 220 by injecting impurity ions into the substrate 201. Alternatively, the source/drain region 214 may be formed at an upper part of the active region AC by forming the device isolation layer 212 and then injecting impurity ions into the substrate 201.

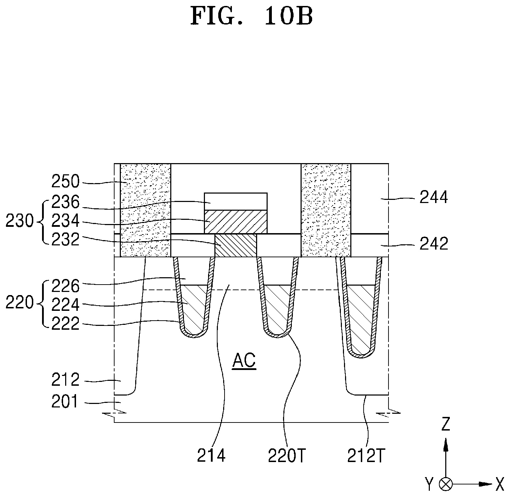

Referring to FIG. 10B, a first interlayer insulating layer 242 may be formed on the substrate 201, and an opening, through which an upper surface of the source/drain region 214 is exposed, may be formed in the first interlayer insulating layer 242.

A conductive layer filling the opening may be formed on the first interlayer insulating layer 242, and an upper part of the conductive layer may be planarized to form, inside the opening, a bit line contact 232 electrically connected to the source/drain region 214.

Next, a bit line 234 and a bit line capping layer 236 extending in the second horizontal direction (e.g., Y direction) parallel to the upper surface of the substrate 201 may be formed by sequentially forming a conductive layer and an insulating layer on the first interlayer insulating layer 242 and patterning the conductive layer and the insulating layer. A bit line spacer may be further formed on side walls of the bit line 234 and the bit line capping layer 236.

Next, a second interlayer insulating layer 244 covering the bit line 234 and the bit line capping layer 236 may be formed on the first interlayer insulating layer 242.

Next, an opening, through which the upper surface of the source/drain region 214 is exposed, may be formed in the first and second interlayer insulating layers 242 and 244, and a contact structure 250 may be formed in the opening. In some embodiments, the contact structure 250 may be formed by sequentially forming a lower contact, a metal silicide layer, and an upper contact inside the opening.

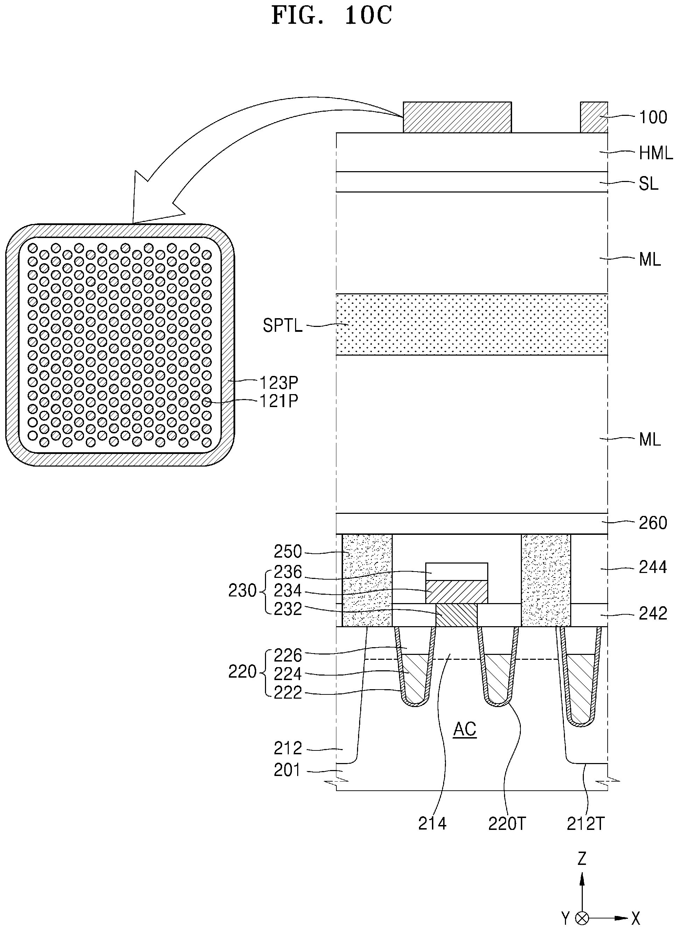

Referring to FIG. 10C, on the second interlayer insulating layer 244 and the contact structure 250, an etching stop layer 260, a mold layer ML, a supporter forming layer SPTL, a sacrificial layer SL, and a hardmask layer HML may be sequentially formed, and then the mask pattern 100 according to the inventive concept may be formed.

The mold layer ML may include silicon oxide. For example, the mold layer ML may use a material, such as boro-phosphorous silicate glass (BPSG), spin on dielectric (SOD), phosphorous silicate glass (PSG), low pressure tetra ethyl ortho silicate (LPTEOS), or plasma enhanced tetra ethyl ortho silicate (PE-TEOS). The mold layer ML may be formed with a thickness of about 500 nm to about 4000 nm but is not necessarily limited thereto.

Next, the supporter forming layer SPTL may be formed between mold layers ML. The supporter forming layer SPTL may include an insulating material, e.g., silicon oxide, silicon nitride, or silicon oxynitride.

Next, the sacrificial layer SL may be formed on the mold layer ML. The sacrificial layer SL may use a material, e.g., tetra ethyl ortho silicate (TEOS), BPSG, PSG, undoped silicate glass (USG), SOD, or high density plasma (HDP) oxide. The sacrificial layer SL may be formed with a thickness of about 50 nm to about 200 nm but is not necessarily limited thereto.

Next, the hardmask layer HML may be formed on the sacrificial layer SL. The hardmask layer HML may use, for example, polysilicon.

Next, an EUV photoresist may be patterned on the hardmask layer HML by exposure and development using the EUV exposure apparatus 1000 (see FIG. 3), and the mask pattern 100 may be formed by the method 5100 (see FIG. 5) of fabricating a semiconductor device, which has been described above. A region in which the lower electrode 270 (see FIG. 10G) is to be formed may be defined by the mask pattern 100.

The mask pattern 100 may include the plurality of main patterns 121P arranged in the first horizontal direction (e.g., X direction) and the second horizontal direction (e.g., Y direction) and the closed quadrilateral periphery pattern, for example, the periphery pattern 123P, at least partially surrounding the plurality of main patterns 121P.

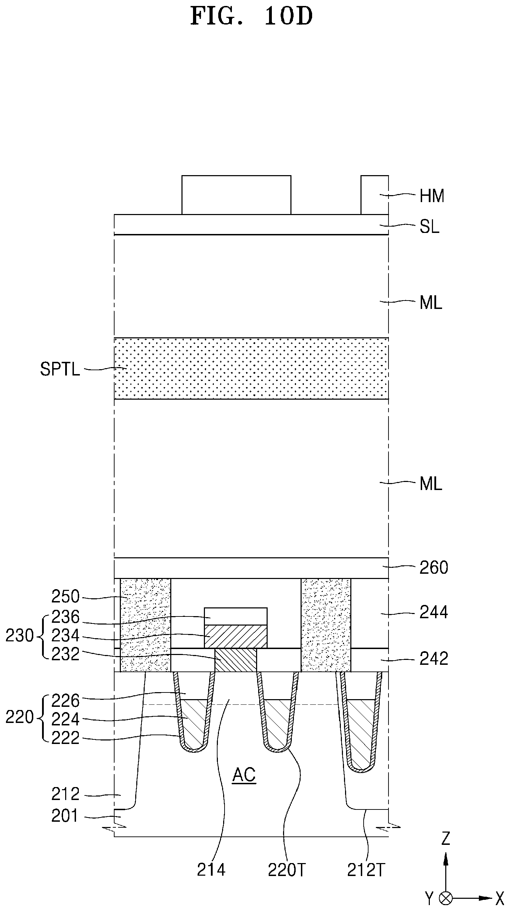

Referring to FIG. 10D, a hardmask pattern HM may be formed by using the mask pattern 100 (see FIG. 10C) as an etching mask to etch the hardmask layer HML (see FIG. 10C).

The hardmask pattern HM may be formed on the sacrificial layer SL according to the shape of the mask pattern 100 (see FIG. 10C).

The hardmask pattern HM may include a material having an etching resistance so that the hardmask pattern HM acts as an etching mask while sequentially etching the sacrificial layer SL, the supporter forming layer SPTL, and the mold layer ML.

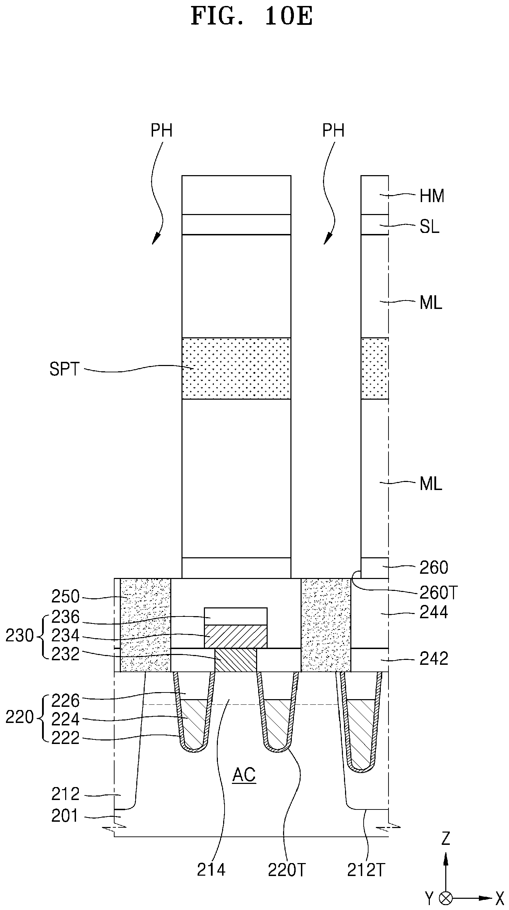

Referring to FIG. 10E, a through hole PH may be formed by using the hardmask pattern HM as an etching mask to sequentially etch the sacrificial layer SL, the supporter forming layer SPTL, and the mold layer ML.

Next, an opening 260T may be formed by removing a part of the etching stop layer 260 exposed on the bottom of the through hole PH. An upper surface of the contact structure 250 may be exposed through the through hole PH and the opening 260T.

Next, the hardmask pattern HM may be removed.

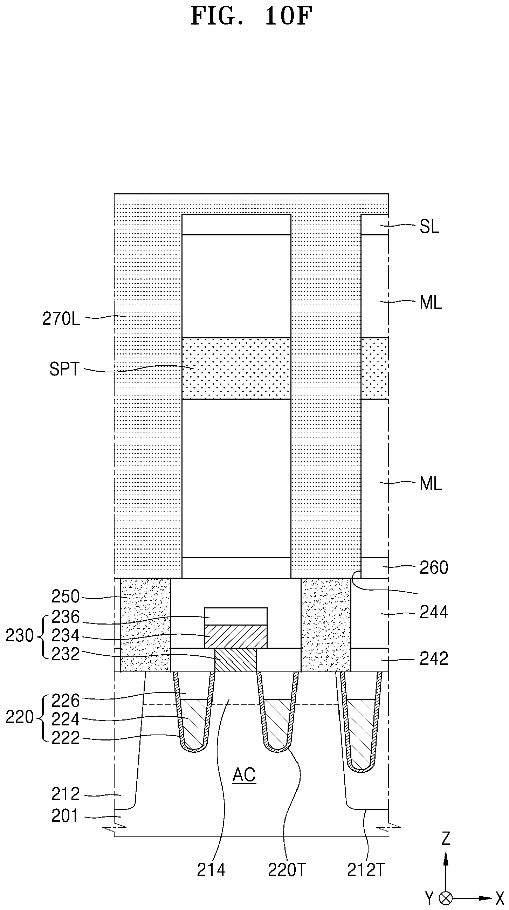

Referring to FIG. 10F, a lower electrode forming layer 270L may be formed to conformally cover inner walls of the through hole PH (see FIG. 10E) and the opening 260T (see FIG. 10E).

In some embodiments, the lower electrode forming layer 270L may be formed on a side surface of the etching stop layer 260, a side surface of the mold layer ML, a side surface of the mold layer ML, and a side surface and an upper surface of the sacrificial layer SL so as to be in contact with the upper surface of the contact structure 250. For example, a process of forming the lower electrode forming layer 270L may use a CVD process or an ALD process.

Referring to FIG. 10G, the lower electrode 270 may be formed by removing, by a node separation process, a portion of the lower electrode forming layer 270L (see FIG. 10F) and the sacrificial layer SL (see FIG. 10F) on an upper surface of the mold layer ML.

The node separation process removes the portion of the lower electrode forming layer 270L (see FIG. 10F) and the sacrificial layer SL (see FIG. 10F) by using an etch-back process or a chemical mechanical polishing (CMP) process.

Next, the mold layer ML may be removed. For example, the mold layer ML may include silicon oxide, and in this case, the mold layer ML may be removed by a wet etching process using a hydrofluoric acid solution or a buffered oxide etchant (BOE).

However, in the wet etching process, a supporter SPT may still remain without being etched and perform a role of firmly supporting the lower electrode 270 so that the lower electrode 270 does not fall down or break. The lower electrode 270 may be disposed on the contact structure 250 and be formed in a pillar shape extending in the vertical direction (e.g., Z direction) from the upper surface of the substrate 201.

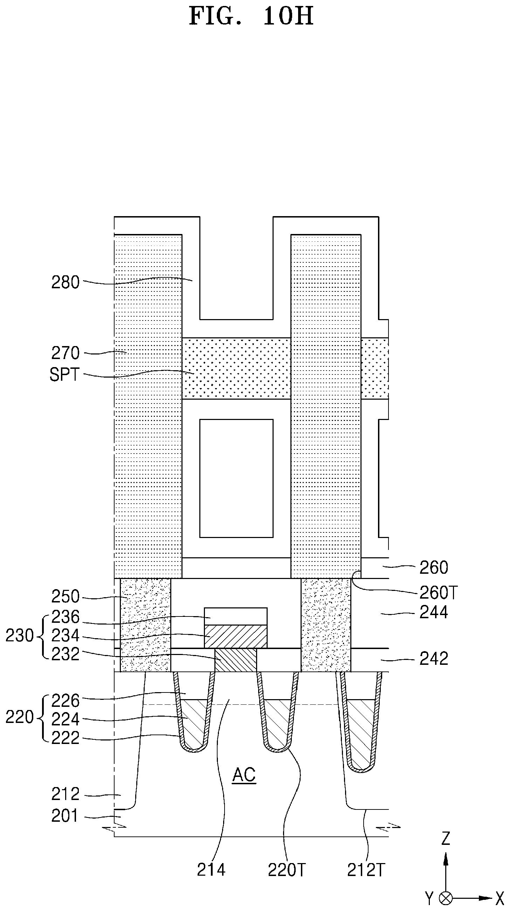

Referring to FIG. 10H, a dielectric layer 280 may be formed on the outer surfaces of the lower electrode 270 and the supporter SPT.

The dielectric layer 280 may be formed of a high-k material having a higher dielectric constant than silicon oxide. For example, the dielectric layer 280 may have a dielectric constant of about 10 to about 25. For example, the dielectric layer 280 may include zirconium oxide (ZrO₂).

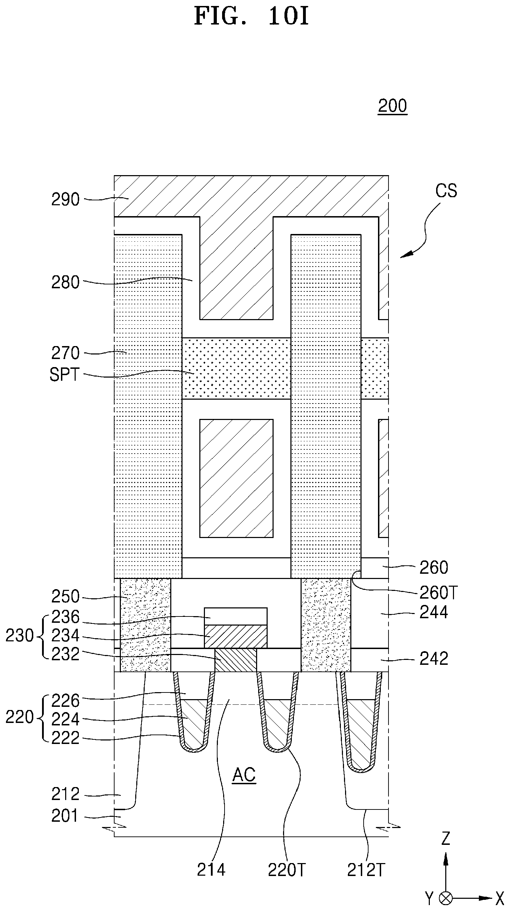

Referring to FIG. 10I, an upper electrode 290 may be formed on the dielectric layer 280 to fill a space defined by an inner wall of the lower electrode 270.

In some embodiments, the upper electrode 290 may be formed to be in direct contact with the dielectric layer 280. The upper electrode 290 may include metal nitride, a metal, or a combination thereof. For example, the upper electrode 290 may include titanium nitride (TiN), tantalum nitride (TaN), tungsten nitride (WN), ruthenium (Ru), platinum (Pt), and/or iridium (Ir).

A semiconductor device 200, according to the inventive concept, may be fabricated by sequentially performing the fabrication processes described above.

The method S200 (see FIG. 9) of fabricating a semiconductor device, according to the technical idea of the inventive concept, may implement a desired mask pattern even without additionally performing an exposure process on any one of different regions of the substrate 201 by forming a plurality of line patterns disposed at different intervals on the different regions, respectively, and applying a double patterning process to the plurality of line patterns, thereby increasing the product reliability and manufacturing economic feasibility of the semiconductor device 200.

While the inventive concept has been particularly shown and described with reference to embodiments thereof, it will be understood that various changes in form and details may be made therein without departing from the scope of the present disclosure.

Further Embodiments are set out in the following Numbered Paragraphs (NPs):
NP1. A method of fabricating a semiconductor device, the method comprising:
   sequentially forming a lower mask layer and an upper mask layer on a substrate in which a cell region and a periphery region at least partially surrounding the cell region are defined;
   forming an extreme ultraviolet (EUV) photoresist pattern comprising a plurality of first line-and-space patterns on the upper mask layer in the cell region, and a plurality of second line-and-space patterns on the upper mask layer in the periphery region;
   etching the upper mask layer by using the EUV photoresist pattern as an etching mask, to form a first mask pattern comprising a plurality of cell lines extending on the lower mask layer in the cell region and separated from one another by a first interval from each other and parallel to each other, and a plurality of periphery lines extending on the lower mask layer in the periphery region and separated from one another by a second interval that is less than the first interval and parallel to each other;
   conformally forming, on the first mask pattern, a spacer layer of a thickness that is less than half of the first interval and greater than half of the second interval;
   etching the spacer layer to form a plurality of cell spacers on side walls of the plurality of cell lines, respectively, and to form a periphery mask covering all of side walls and upper surfaces of the plurality of periphery lines;
   removing the plurality of cell lines to form, on the lower mask layer, a second mask pattern including the plurality of cell spacers and the periphery mask;
   etching the lower mask layer by using the second mask pattern as an etching mask, to form a plurality of cell patterns in the cell region and to form a single dam pattern in the periphery region; and
   removing the second mask pattern and the plurality of periphery lines to form, on the substrate, a third mask pattern including the plurality of cell patterns and the single dam pattern.
NP2. The method of NP1, wherein, in the forming of the EUV photoresist pattern, a first horizontal width of lines of the plurality of first line-and-space patterns is greater than a second horizontal width of lines of the plurality of second line-and-space patterns.
NP3. The method of NP1, wherein a first height of the plurality of cell lines is substantially the same as a second height of the plurality of periphery lines,
   wherein the spacer layer is conformally formed with a same first thickness along a side wall and an upper surface of each of the plurality of cell lines, and
   wherein the spacer layer is formed to fill a space between the plurality of periphery lines and is formed with a second thickness that is greater than the first thickness in a vertical direction from upper surfaces of the plurality of periphery lines.
NP4. The method of NP3, wherein the spacer layer is formed by an atomic layer deposition process, and
   wherein in the periphery region, the narrower the second interval between the plurality of periphery lines, the greater the second thickness of the spacer layer.
NP5. The method of NP1, wherein the second interval of the plurality of second line-and-space patterns has a resolution corresponding to a wavelength of EUV light of about 4 nm to about 124 nm.

## Claims

1. A method of fabricating a semiconductor device, the method comprising:
forming a mask layer on a substrate in which a cell region and a periphery region at least partially surrounding the cell region are defined;
forming a first mask pattern comprising a plurality of cell lines extending on the mask layer in the cell region, the plurality of cell lines being separated from one another by a first interval and being parallel to each other, the first mask pattern further comprising a plurality of periphery lines extending on the mask layer in the periphery region, the plurality of periphery lines being separated from one another by a second interval that is less than the first interval, the plurality of periphery lines being parallel to each other;
conformally forming, on the first mask pattern, a spacer layer of a thickness that is less than half of the first interval and greater than half of the second interval;
etching the spacer layer to form a plurality of cell spacers on side walls of the plurality of cell lines, respectively, and to form a periphery mask covering all side walls and upper surfaces of the plurality of periphery lines;
removing the plurality of cell lines to form, on the mask layer, a second mask pattern including the plurality of cell spacers and the periphery mask;
etching the mask layer by using the second mask pattern as an etching mask, to form a plurality of cell patterns in the cell region and to form a single dam pattern in the periphery region; and
removing the second mask pattern and the plurality of periphery lines to form, on the substrate, a third mask pattern having the plurality of cell patterns and the single dam pattern.

2. The method of claim 1, wherein, in the conformally forming the spacer layer,
the spacer layer is formed by an atomic layer deposition process,
the spacer layer is conformally formed with a same first thickness along a side wall and an upper surface of each of the plurality of cell lines, and
the spacer layer is formed to fill a space between the plurality of periphery lines and the spacer layer is formed with a second thickness that is greater than the first thickness in a vertical direction from upper surfaces of the plurality of periphery lines.

3. The method of claim 2, wherein, in the periphery region, the narrower the second interval between the plurality of periphery lines, the greater the second thickness of the spacer layer.

4. The method of any preceding claim, wherein, in the forming of the second mask pattern,
the spacer layer on upper surfaces of the plurality of cell lines is removed so that the upper surfaces of the plurality of cell lines are exposed, and
a portion of the spacer layer on upper surfaces of the plurality of periphery lines remains so that the upper surfaces of the plurality of periphery lines are not exposed.

5. The method of claim 4, wherein, when the plurality of cell lines are removed, the plurality of periphery lines are not removed.

6. The method of claim 4 or claim 5, wherein a first height of the plurality of cell spacers in a vertical direction is less than a second height of the periphery mask in the vertical direction.

7. The method of any preceding claim, wherein, in the forming of the first mask pattern, the plurality of cell lines and the plurality of periphery lines have straight line shapes separated from each other in a first horizontal direction and extending in a second horizontal direction that is perpendicular to the first horizontal direction.

8. The method of any one of claims 1-6, wherein, in the forming of the first mask pattern,
the plurality of cell lines have straight line shapes separated from each other in a first horizontal direction and extending in a second horizontal direction that is perpendicular to the first horizontal direction, and
the plurality of periphery lines have a mesh shape extending in the first horizontal direction and the second horizontal direction.

9. The method of any preceding claim, wherein, in the forming of the first mask pattern,
the first mask pattern comprises a lower mask pattern and an upper mask pattern, and
a thickness of the lower mask pattern in a vertical direction is greater than a thickness of the upper mask pattern in the vertical direction.

10. The method of any preceding claim, wherein the second interval of the plurality of periphery lines has a resolution corresponding to a wavelength of extreme ultraviolet (EUV) light.

11. The method of any preceding claim, the method comprising:
forming an upper mask layer on the mask layer in which the cell region and the periphery region at least partially surrounding the cell region are defined;
forming an extreme ultraviolet (EUV) photoresist pattern comprising a plurality of first line-and-space patterns on the upper mask layer in the cell region, and a plurality of second line-and-space patterns on the upper mask layer in the periphery region;
wherein forming the first mask pattern comprises etching the upper mask layer by using the EUV photoresist pattern as an etching mask, to form the first mask pattern.

12. The method of claim 11, wherein, in the forming of the EUV photoresist pattern, a first horizontal width of lines of the plurality of first line-and-space patterns is greater than a second horizontal width of lines of the plurality of second line-and-space patterns.

13. The method of claim 11 or claim 12, wherein a first height of the plurality of cell lines is substantially the same as a second height of the plurality of periphery lines,
wherein the spacer layer is conformally formed with a same first thickness along a side wall and an upper surface of each of the plurality of cell lines, and
wherein the spacer layer is formed to fill a space between the plurality of periphery lines and is formed with a second thickness that is greater than the first thickness in a vertical direction from upper surfaces of the plurality of periphery lines.

14. The method of claim 13, wherein the spacer layer is formed by an atomic layer deposition process, and
wherein in the periphery region, the narrower the second interval between the plurality of periphery lines, the greater the second thickness of the spacer layer.

15. The method of any one of claims 11 - 14, wherein the second interval of the plurality of second line-and-space patterns has a resolution corresponding to a wavelength of EUV light of about 4 nm to about 124 nm.
